# EUROPEAN PATENT APPLICATION

(11) **EP 1 168 534 A2**
(43) Date of publication of application: **02.01.2002**
(21) Application number: 01115077.8
(22) Date of filing: 21.06.2001
(51) Int. Cl.: H01S 3/13, H04B 10/04, H04B 10/18, G02F 1/035

(54) **Method and apparatus for reduction of electrical cross-talk and wave length chirp in a distributed bragg reflector laser**

(30) Priority: 28.06.2000 US 606795
(71) Applicant: Agere Systems Optoelectronics Guardian Corporation, Orlando, Florida 32819-8698 (US)
(72) Inventor: Eng, Lars Eric, Fogelsville, Pennsylvania 18051 (US); Hartmann, Robert Louis, Warren Township, New Jersey 07059 (US); Wilt, Daniel Paul, Orefield, Pennsylvania 18069 (US); Shtengel, Gleb E., Baltimore, Maryland 21231 (US)
(74) Representative: Callies, Rainer

(57) **Abstract**

A shunt capacitor is placed in parallel with the tuning section of a tunable electro-absorption modulated Distributed Bragg Reflector (DBR) laser. This reduces the electrical cross-talk between the modulator and tuning sections of the device. This reduction of electrical cross-talk results in a reduction of the wavelength chirp and therefore reduces the pulse distortion of a light wave traveling along an optical fiber.

## Description

### Field of the Invention

The present invention relates to a method and apparatus for reducing the electrical cross-talk between sections of a tuneable electroabsorption modulated laser and the wavelength chirp associated therewith.

### Description of the Related Art

Optical fiber technology is currently utilized in communications systems to transfer information, e.g., voice signals, and data signals, over long distances. As is well known, the use of optical fiber technology involves the modulation of light, generally a laser light, for use as a carrier to transmit the desired signals along an optical fiber. Currently, undersea fiber optic telecommunication cables provide intercontinental telecommunication links and the demand for such communication connections is rapidly increasing.

Two general approaches are typically used to modulate laser light: direct modulation and external modulation. In direct modulation, a laser (e.g., a laser diode), is directly modulated by an information signal to generate a modulated laser output. In external modulation, a modulator is used to modulate light from a laser source. An information signal is then input to the modulator which in turn modulates the output laser light.

During laser modulation of either the direct or external type, a minimum level of spectral broadening, or "chirp," necessarily occurs. Excess chirp can occur when an excess of spectral broadening beyond the spectral width required for modulation occurs. When excess chirp exists, the ability to transmit information over an optical fiber is degraded. Because different wavelengths propagate at different speeds in a dispersive medium, such as an optical fiber, the presence of significant chirp causes greater pulse spreading for a modulated optical signal transmitted across a fiber optic network, thereby causing increased pulse distortion along the length of the fiber. Thus, reducing chirp has long been desired in optical communication.

External modulation is favored in applications sensitive to chirp, such as long-distance optical communications, where the excessive spectral broadening in the emitted modulated light due to chirp leads to a greater pulse distortion during propagation and a reduction in overall performance. There are two basic packaging techniques used in external modulation systems, and the technique selected affects the amount of chirp in the system. In the first technique, the modulator and laser are disposed on separate, discrete substrates. In the second technique, the modulator and laser are fabricated as an integrated modulator substrate on a common chip.

External modulation can also have a secondary source of chirp in addition to the sources mentioned above. Chirp can arise from electrical and optical crosstalk between the laser and the modulator. Thus, in an integrated external modulation arrangement in which the laser and modulator are fabricated as a single chip, the electrical and optical crosstalk between the laser and modulator is significant due to their close proximity to each other. This problem is discussed in Marcuse, D. et al., "Time-Dependent Simulation of a Laser-Modulator Combination," IEEE J. of Quantum Electron. 30 (12):2743-2755 (December 1994). Thus, the reduction of chirp in integrated laser arrangements is even more important than in separate laser-modulator arrangements.

The electrical and optical interactions of distributed feedback lasers (DFB's) and modulators is discussed in Suzuki, M. et al., "Electrical and Optical Interactions Between Integrated InGaAsP/InP DFB Lasers and Electroabsorption Modulators," J. Lightwave Technol. 6(6):779-784 (June 1988). As discussed in this article, RF bypass condensers can be connected to the laser section of an integrated DFB laser modulator to reduce the crosstalk.

To achieve a wavelength tunable laser source, a Distributed Bragg Reflector (DBR) laser is preferred over the DFB laser. The DBR laser can also be integrated with a modulator. In contrast to DFB lasers, DBR lasers have a tuning section which can be up to 100 times more sensitive to cross-talk than the laser section of a DFB laser.

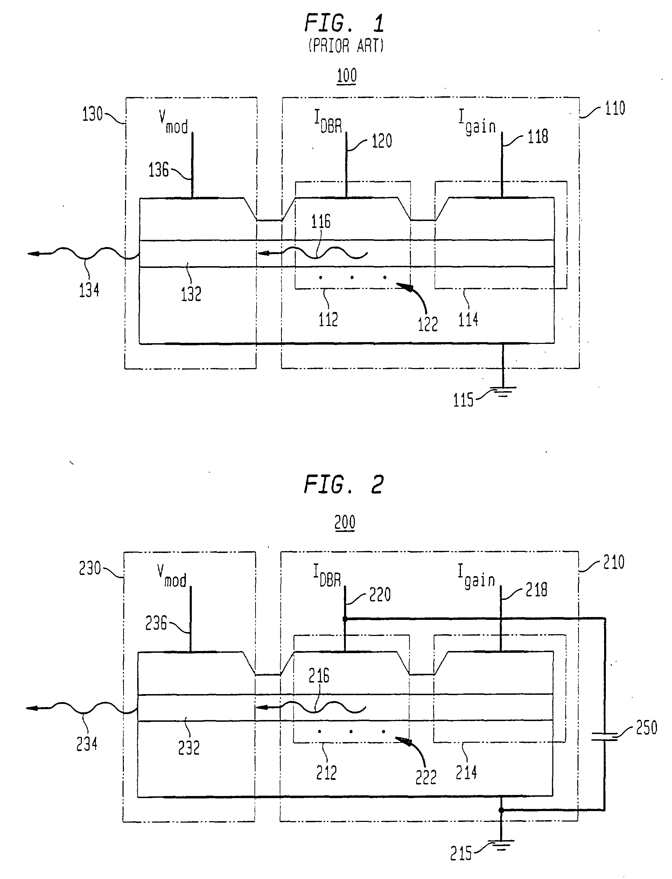

Figure 1 illustrates the general configuration of a prior art DBR laser. As shown in Fig. 1, a tunable electro-absorption modulator laser 100 includes a laser section 110 and a modulator section 130. Laser section 110 includes a tuning section 112 and a gain section 114. Other sections (not shown) may also be included, such as a phase section or an additional tuning section. The operating current for the tuning section 112 is provided via electrode 120 and the operating current for the gain section 114 is provided via gain electrode 118. An optical waveguide 132 spans the length of the laser section 110 and modulator section 130 providing a path along which the optical signals may travel.

A grating 122 functions in a well-known manner to set the laser wavelength by adjusting the tuning current. An unmodulated (continuous wave or CW) tunable light signal 116 is transmitted along the optical waveguide 132 and is modulated by modulator section 130, thereby outputting a modulated signal 134. As is well known, the unmodulated tunable light signal 116 is encoded with signal information (e.g., the bit pattern that needs to be transmitted) as it travels in the waveguide through the modulator section 130.

As shown in Fig. 1, the modulator section 130 is adjacent to the laser section 110. Because of this close proximity, electrical cross talk between the adjacent sections occurs and the AC component of the modulator input 136 (which contains the signal information) provides parasitic voltage and, hence, current modulation to the laser section 110. This parasitic current modulation in the laser section 110, especially in the tuning section 112, leads to parasitic wavelength chirp in the CW signal 116 generated in the laser section 110.

What is needed then is a method and apparatus for reducing cross-talk in a DBR laser, and particularly for configurations in which the DBR laser is integrated with a modulator.

### Summary of the Invention

In accordance with the present invention, a shunt capacitor is placed in parallel with the tuning section of a tunable laser, for example, in the tuning section of a tunable electro-absorption modulated Distributed Bragg Reflector (DBR) laser. This reduces the electrical cross-talk between the modulator section and the tuning section of the device. This reduction of electrical cross-talk results in a reduction of the wavelength chirp and therefore reduces the pulse distortion of a light wave traveling along an optical fiber.

According to one embodiment of the invention, chirp is reduced in a tunable laser by placing a capacitance in parallel with the tuning section of the laser.

In one implementation of this embodiment, the capacitance is fabricated on a single substrate integrally with the tuning section and a modulation section of the laser.

In a second implementation of this embodiment, the capacitance comprises a capacitor integrated into the laser source, and in a third embodiment, the capacitance comprises an external capacitor.

Further features and advantages of the present invention, as well as the structure and operation of various embodiments of the present invention, are described in detail below with reference to the accompanying drawings.

### Brief Description of the Drawings

Figure 1 illustrates a prior art tunable Distributed Bragg Reflector (DBR) laser;
Figure 2 illustrates a tunable DBR laser in accordance with the present invention;
Figure 3 illustrates an equivalent circuit model of the tuneable DBR laser of Fig. 2; and
Figure 4 illustrates a tunable laser in accordance with the present invention in which the tuning section and the modulation section are integrally fabricated.

### Description of the Preferred Embodiment

Figure 2 illustrates one example of a tunable DBR laser configured in accordance with the present invention. As shown in Fig. 2, a shunt capacitor 250 is placed in parallel with the DBR electrode 220 of tuning section 212 and common ground 215. The shunt capacitor 250 must be large enough (i.e., have enough capacitance) to short out AC signals. In a preferred embodiment, tuning section 212 comprises a forward biased heterostructure diode A modulator section 230 comprises a capacitive load connected in series with the tuning section 212.

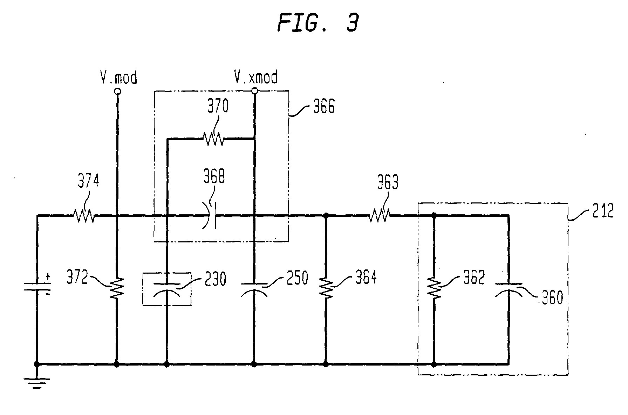

Figure 3 illustrates an equivalent circuit model corresponding to the tunable DBR laser illustrated in Figure 2. In Figure 3, tuning section 212 is illustrated as a parallel capacitance 360 and resistance 362 connected in series with resistance 363 (representing the resistance of the cladding semiconductor). Resistance 364 represents the impedance of the circuit driving the tuning section, i.e., an external load. The coupling 366 between tuning section 212 and the modulator section 230 is functionally equivalent to a parallel capacitance 368/resistance 370 as shown. The modulator section 230 comprises a capacitive load as shown. Resistance 372 comprises a chip resistor termination located close to the laser chip to avoid back reflections, and resistance 374 connected in series with the voltage source represents the drive impedance of the voltage source. The shunt capacitance of the present invention is illustrated by shunt capacitor 250.

In the equivalent circuit of Figure 3, a value of C>1000 pF for shunt capacitor 250 will give a cross-talk induced value of chirp of less than 0.2 A at 1 GHz. Typical values for shunt capacitor 250 range from 100 pF to 100000 pF, depending on the level of chirp reduction desired or required. Generally the impedance of the shunt capacitance should be small as compared to the impedance of the coupling 366 between the modulator section 230 and the tuning section 212 over the frequency range of interest. This general requirement places two limitations on the shunt capacitor: its capacitive value should be much larger than that of capacitance 368, so as to shunt high frequencies, and it should be large enough to have a much lower impedance than resistance 370 at lower frequencies. The upper limit on the value of shunt capacitor 250 is determined by physical size limitations of the design itself, and the departure of capacitive behavior at high frequencies due to inductive components in the structure of the capacitance.

In a preferred embodiment, the shunt capacitor 250 comprises a capacitor in the 500 - 1,500 pF range. While any capacitor in the range of 100-100,000 pF will suffice, the use of a capacitor in the 500 - 1500 pF range strikes a balance between the desire to shunt high frequencies (i.e., a 1000 pF capacitor is generally much larger in terms of capacitance than the capacitance of the coupling between the tuning section 212 and a modulator section 230, thus shunting high frequencies) and the desire to have good capacitive shunting over a broad frequency range (i.e., high value capacitors tend to deviate from capacitive behavior at high frequencies due to lead inductances and internal resistance).

A good method of estimating a sufficient capacitance for the shunt capacitor for a particular laser configuration can be determined by the ratio of the resistance 370 to resistance 363, multiplied by the capacitance 368, and the actual optimal value will vary dependent upon the resistance/impedance of the coupling between the modulator and tuning sections and the resistance of the cladding semiconductor. For example, if resistance 370 is a 14K resistor and resistance 363 is a 7 ohm resistor, and capacitance 368 is a 0.28 pF capacitor, a sufficient value for shunt capacitor 250 could be calculated to be 2000 × 0.28 pF = 560 pF.

In a preferred embodiment the shunt capacitor is mounted as closely as possible to the laser section 210, generally within a small fraction of an electrical wavelength at the highest frequency of interests, e.g., for 10 Gb/s modulation, at least within a centimeter, and preferably a millimeter or two of the laser section 210. By mounting the components so closely together, any resonance due to bond wires and a capacitor is well beyond one GHz. The following are typical values for the elements of the equivalent circuit of Figure 3:

| **Figure 3 Item No.** | **Typical Value** |
|---|---|
| 230 | 1.4 pF |
| 360 | 0.4 nF |
| 362 | 5 Ohms |
| 363 | 7 Ohms |
| 368 | 0.25 pF |
| 370 | 14 kOhm |
| 372 | 50 Ohms |
| 250 | _1000 pF |

Configured in such a manner, the capacitor 250 suppresses virtually all electrical cross-talk and passes only the DC component of the tuning current.

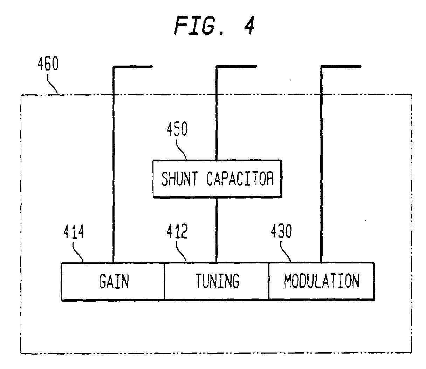

In accordance with an alternative embodiment, the shunt capacitor may be integrated into the substrate on which the tuning section and modulation section are fabricated. Fig. 4 illustrates an example of this embodiment, in which shunt capacitor 450, gain section 414, tuning section 412, and modulation section 430 are all integrally formed on substrate 460. The fabrication can be performed using conventional fabrication methods; the actual technique used does not, in and of itself, constitute a novel aspect of the present invention.

While there has been described herein the principles of the invention, it is to be understood by those skilled in the art that this description is made only by way of example and not as a limitation to the scope of the invention. For example, while the examples and embodiments above describe the use of the present invention in connection with tunable laser devices, which are very susceptible to crosstalk, the present invention is not limited to tunable devices and has application in any integrated laser-modulator device. Accordingly, it is intended by the appended claims, to cover all modifications of the invention which fall within the true spirit and scope of the invention.

## Claims

1. An optical transmitter comprising:
a laser source having a tuning section and a modulation section; and
a capacitance connected in parallel with said tuning section.

2. An optical transmitter as set forth in claim 1, wherein said tuning section and said modulation section are fabricated integrally on a single substrate.

3. An optical transmitter as set forth in claim 1, wherein said laser source comprises a tuneable distributed Bragg reflector (DBR) laser.

4. A optical transmitter as set forth in claim 1, wherein said capacitance comprises a capacitor integrated into said laser source.

5. A optical transmitter as set forth in claim 2, wherein said capacitance comprises a capacitor integrated into said single substrate.

6. A optical transmitter as set forth in claim 1, wherein said capacitance comprises an external capacitor.

7. An optical transmitter as set forth in claim 1, wherein said capacitance has a capacitance of approximately 100 pF to 10,000 pF.

8. An optical transmitter as set forth in claim 7, wherein said capacitance has a capacitance of about 1,000 pF.

9. A method for reducing chirp in a tuneable laser having a tuning section, comprising the step of:
placing a capacitance in parallel with said tuning section.

10. A method as set forth in claim 9, wherein said capacitance comprises a capacitor integrated into said tuning section.

11. A method as set forth in claim 9, wherein said laser includes a modulation section fabricated integrally with said tuning section on a single substrate and wherein said capacitance comprises a capacitor integrated into said single substrate.

12. A method as set forth in claim 9, wherein said capacitance comprises an external capacitor.

13. A method as set forth in claim 9, wherein said capacitance has a capacitance of approximately 100 pF to 10,000 pF.

14. A method as set forth in claim 13, wherein said capacitance has a capacitance of about 1,000 pF.

15. An optical communications system comprising:
laser means, having a tuning section and a modulation section, for generating a laser signal; and
capacitance means, connected in parallel with said tuning section, for filtering out any noise resulting from interaction between said tuning section and said modulation section.

16. An optical communications system as set forth in claim 15, wherein said tuning section and said modulation section are fabricated integrally on a single substrate.

17. An optical communications system as set forth in claim 16, wherein said laser means comprises a tuneable distributed Bragg reflector (DBR) laser.

18. A optical communications system as set forth in claim 15, wherein said capacitance means comprises a capacitor integrated into said laser source.

19. A optical communications system as set forth in claim 16, wherein said capacitance means comprises a capacitor integrated into said single substrate.

20. A optical communications system as set forth in claim 15, wherein said capacitance means comprises an external capacitor.

21. An optical communications system as set forth in claim 15, wherein said capacitance means has a capacitance of approximately 100 pF to 10,000 pF.

22. An optical communications system as set forth in claim 21, wherein said capacitance means has a capacitance of about 1,000 pF.
